# EUROPÄISCHE PATENTANMELDUNG

(11) **EP 1 315 185 A1**
(43) Veröffentlichungstag der Anmeldung: **28.05.2003**
(21) Anmeldenummer: 02102546.5
(22) Anmeldetag: 07.11.2002
(51) Int. Cl.: H01G 4/33, H01B 13/00

(54) **Flacher Kondensator und Leiterplatte, die ihn einbettet**

(30) Priorität: 10.11.2001 DE 10155393
(71) Anmelder: Philips Intellectual Property & Standards GmbH, 20099 Hamburg (DE); Koninklijke Philips Electronics N.V., 5621 BA Eindhoven (NL)
(72) Erfinder: Waffenschmidt, Eberhard c/o Philips Corporate, 52088, Aachen (DE); Lürkens, Peter c/o Philips Corporate, 52088, Aachen (DE)
(74) Vertreter: Volmer, Georg, Dipl.-Ing.

(57) **Zusammenfassung**

Die Erfindung betrifft ein elektronisches Bauelement, die Verwendung eines solchen Bauelementes und ein Verfahren zur Herstellung eines solchen Bauelementes mit kapazitiven Eigenschaften. Zur Integration eines Elektrolyt-Kondensators in integrierten Schaltkreisen wird vorgeschlagen, einen Polymer-Elektrolyt-Kondensator geschichtet (2,4,6,8) planar auszuführen. Dadurch wird es möglich, einen Elektrolyt-Kondensator in einer Leiterplatte (10) zu integrieren, wodurch sich die Baugröße, die Herstellbarkeit und die elektromagnetische Verträglichkeit einer solchen Schaltung verbessert.

## Beschreibung

Die Erfindung betrifft ein elektronisches Bauelement mit kapazitiven Eigenschaften, insbesondere Kondensatoren, mit zumindest einer ersten, eine leitfähige Schicht aufweisenden Elektrode, mit zumindest einer zweiten, eine leitfähige Schicht aufweisenden Elektrode und mit zumindest einer zwischen der ersten und der zweiten Elektrode angeordneten leitfähigen Polymer-Schicht.

Des weiteren betrifft die Erfindung ein Verfahren zur Herstellung eines solchen Bauelementes sowie die Verwendung eines solchen Bauelementes in Flachbildschirmen.

Elektrolyt-Kondensatoren sind wesentliche Bauteile einer elektronischen Schaltung. Da sie sich durch eine sehr hohe Energiedichte auszeichnen, werden sie im allgemeinen als Energiespeicher verwendet. Diese Energiespeicher werden in den meisten elektronischen Schaltungen benötigt. Jedoch nehmen die Elektrolyt-Kondensatoren bis zu einem Drittel des Volumens einer Schaltung ein und bestimmen dadurch häufig die Bauhöhe der gesamten Schaltung.

Aus der Druckschrift US 6,212,064 B1 ist ein Elektrolyt-Kondensator bekannt, bei dem keine leitfähige Elektrolyt-Flüssigkeit zwischen den Elektroden eingebracht ist, sondern ein leitfähiger Polymer als Elektrolyt dient. Dieser gewickelte Kondensator weist eine erste Elektrode auf. Diese erste Elektrode ist mit einer leitfähigen Schicht beaufschlagt. Eine zweite Elektrode ist ebenfalls vorgesehen, die mit einer dielektrischen Schicht überzogen ist. Zwischen der dielektrischen Schicht der zweiten Elektrode und der leitfähigen Schicht der zweiten Elektrode befindet sich eine Polymer-Schicht als Elektrolyt. Durch die Verwendung der Polymer-Schicht kann auf eine Abdichtung des Gehäuses im wesentlichen verzichtet werden, da keine Elektrolyt-Flüssigkeit aus dem Kondensator ausfließen kann.

Nachteilig an der beschriebenen Anordnung ist jedoch, dass dieser Polymer-Kondensator sich nicht in Schaltungen integrieren lässt. Seine Bauhöhe lässt eine miniaturisierte Schaltung nicht zu.

Ausgehend von dem beschriebenen Elektrolyt-Kondensator liegt der Erfindung die Aufgabe zugrunde, einen Elektrolyt-Kondensator zur Verfügung zu stellen, der hochintegrierbar ist.

Diese Aufgabe wird erfindungsgemäß dadurch gelöst, dass die Elektroden und die Polymer-Schicht zumindest einfach planar geschichtet sind und dass zumindest eine leitfähige Schicht zumindest eine dielektrische Schicht aufweist. Somit ist es im Gegensatz zu bekannten kapazitiven Lösungen für Leiterplatten möglich, eine um mehrere Größenordnungen größere Kapazität zu integrieren. Durch die planare Ausführung lassen sich die Elektrolyt-Kondensatoren ultradünn und planar ausführen und höhere Formfaktoren als bisher erreichen. Weiterhin ist der Einsatz von Kunststoff-Polymeren weitaus günstiger, da auf ein Gehäuse verzichtet werden kann. Ferner kann auf eine giftige Elektrolyt-Flüssigkeit verzichtet werden, was die Umweltverträglichkeit erfindungsgemäßer Kondensatoren erhöht. Schließlich lassen sich erfindungsgemäße Elektrolyt-Kondensatoren gut wiederverwerten, da durch den geschichteten Aufbau ein standardisiertes Recycle-Verfahren einsetzbar ist.

Durch den erfindungsgemäßen Aufbau lässt sich die Kapazität des erfindungsgemäßen Kondensators steigern. Auch können Spannungsfestigkeit, elektrische Verluste und Temperatur- bzw. Frequenzverhalten des Kondensator eingestellt werden. Insbesondere ist dies durch den Einsatz einer dielektrischen Schicht möglich.

Bei einer Anordnung gemäß Anspruch 2 ist der Kondensator bereits auf oder in einem Schaltungsträger angeordnet. Ein Schaltungsträger kann dabei sowohl eine Leiterplatte, als auch ein Halbleiterträger sein. Dieser Halbleiterträger kann z.B. ein Silizium-Kristall sein, auf dem elektronische Bauelemente mit Hilfe geeigneter Verfahren, wie beispielsweise Ätzen, Aufwachsen oder Aufdampfen aufgebracht werden können. Durch die Integration in den Schaltungsträger lässt sich die Baugröße, die elektromagnetische Verträglichkeit und die Herstellbarkeit solcher Schaltungsträger mit kapazitiven Eigenschaften verbessern. Die Bauhöhe einer Schaltung lässt sich durch die Integration in einen Schaltungsträger erheblich reduzieren. Auch lässt sich die Gesamtgröße der Schaltung reduzieren, da die Abstände zwischen einzelnen integrierten Bauteilen kleiner sein können. Ist der Kondensator innerhalb der Leiterplatte angeordnet, so beansprucht er nicht die Oberfläche der Leiterplatte, wodurch eine höhere Integrationsdichte erreichbar ist.

Durch die Integration verschiedener Bauelemente in einem Schaltungsträger gemäß Anspruch 3 lässt sich auf nur einem Schaltungsträger ein integrierter Schaltkreis implementieren. Der Herstellungsprozess für eine solche integrierte Schaltung ist einfach, da die unterschiedlichen Bauelemente in gemeinsamen Prozessen auf den Schaltungsträger aufgebracht werden können. Solche Bauelemente sind beispielsweise Dioden, Widerstände, integrierte Spulen, LCT-Komponenten, Schalter, integrierte Schaltkreise und Filter.

Durch eine Schichtung gemäß Anspruch 4 lässt sich eine höhere Integrationsdichte erreichen. Jede einzelne Schicht kann dabei unterschiedliche Bauelemente nebeneinander aufweisen. Durch die geschichtete Anordnung verringert sich der Abstand zwischen einzelnen Bauteilen, wodurch die elektromagnetische Verträglichkeit verbessert wird. Störungen lassen sich durch den mehrlagigen Aufbau besser kompensieren.

Gemäß einer Anordnung nach Anspruch 5 können die einzelnen Schichten unterschiedliche Eigenschaften aufweisen. So lassen sich beispielsweise Stoffe mit unterschiedlichen Permeabilitäten aufbringen und somit die magnetischen Eigenschaften einer einzelnen Schicht verändern. Auch lassen sich Stoffe mit unterschiedlichen Dielektrizitätskonstanten auf einer Schicht aufbringen. Weiterhin kann eine Schicht als Widerstandsschicht ausgeführt sein. Schließlich ist es noch möglich, dass eine Schicht aus dotierten und nicht dotierten Halbleiterelementen besteht und somit Halbleiterbauelemente auf den Schichten implementiert werden können. Dadurch, dass verschiedene Schichten verschiedene Eigenschaften aufweisen, lassen sich nahezu alle Funktionen auf nur einem Schaltungsträger realisieren.

Durch eine Strukturierung nach Anspruch 6 lassen sich in einer Lage verschiedene Kondensatoren realisieren. Die Struktur kann durch geeignete Verfahren, beispielsweise Ätzen, in jeder Schicht realisiert werden.

Gemäß eines weiteren Gegenstands der Erfindung wird die Verwendung eines vorbeschriebenen elektronischen Bauelementes in Flachbildschirmen oder für Leistungskonverter vorgeschlagen. Dabei kommen insbesondere Plasmabildschirme in Frage. Durch die Integration der Elektrolyt-Kondensatoren in die Leiterplatte lässt sich eine dünne Bauweise der Flachbildschirme realisieren.

Gemäß eines weiteren Gegenstandes der Erfindung wird ein Verfahren zur Herstellung eines vorbeschriebenen Bauelementes angegeben, bei dem auf einen Schaltungsträger zumindest eine erste leitfähige Schicht aufgebracht wird, bei dem auf die erste Schicht zumindest ein Dielektrikum aufgebracht wird, bei dem auf das Dielektrikum zumindest eine Polymer-Schicht aufgebracht wird und bei dem auf die Polymer-Schicht zumindest eine zweite leitfähige Schicht aufgebracht wird.

Bevorzugte Verwendungen des erfindungsgemäßen Bauelementes ergeben sich aus den Ansprüchen 10 bis 15.

Die Erfindung wird im folgenden anhand eines Ausführungsbeispiels näher erläutert. In der Zeichnung zeigen:
- Fig. 1: einen prinzipiellen Aufbau eines geschichteten Kondensators;
- Fig. 2: einen integrierten Schaltkreis mit erfindungsgemäßen kapazitiven Bauelementen.

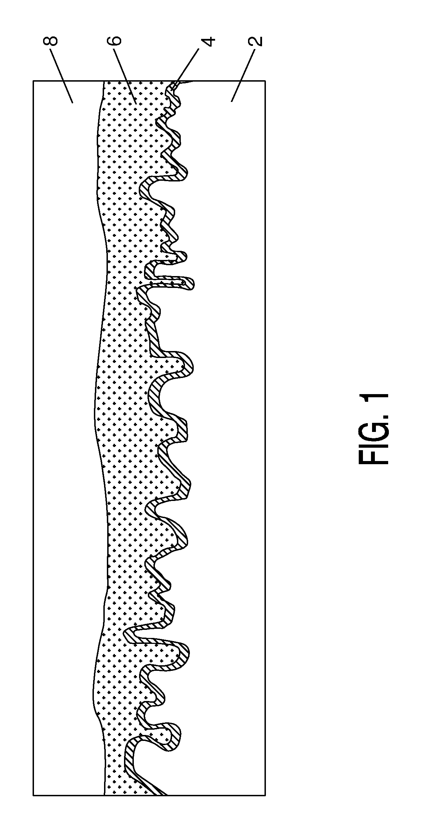

Die Figur 1 zeigt die Schichtung eines Polymer-Kondensators. Zwischen einer ersten Elektrode 2 und einer zweiten Elektrode 8 ist eine Polymer-Schicht 6 und eine dielek trische Schicht 4 angeordnet. Der leitende Polymer-Kunststoff 6 gewährleistet den elektrischen Kontakt zwischen der zweiten Elektrode 8 und der dielektrischen Schicht 4.

Zur Herstellung einer solchen Struktur wird üblicherweise ein zunächst flüssiger Polymer-Kunststoff genutzt, der in einem zweiten Arbeitsschritt beispielsweise durch Erwärmen verfestigt wird.

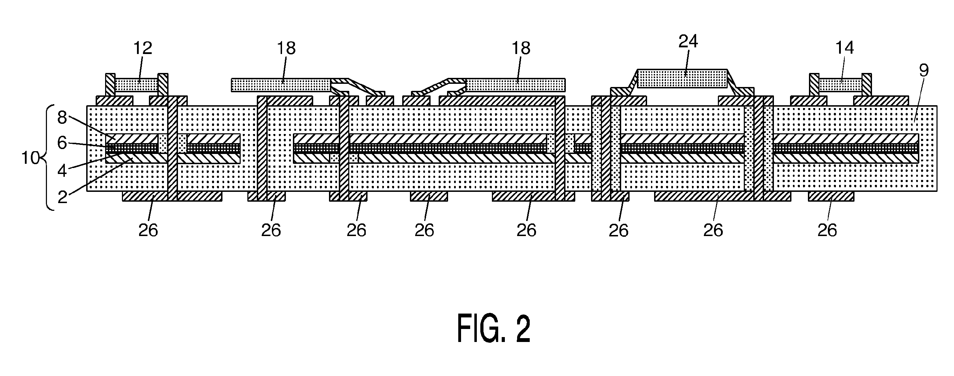

Die erste Elektrode 2 ist zumeist eine Aluminium-Folie. Diese ist stark aufgerauht, um die Oberfläche zu vergrößern. Danach wird eine dünne, durchgehende Aluminium-Oxid-Schicht oder ein ähnlicher dielektrischer Isolator als dielektrische Schicht 4 auf der Folie gebildet. Der flüssige Polymer-Kunststoff wird auf die rauhe dielektrische Schicht 4 aufgetragen und dringt in alle Unebenheiten ein. Dadurch wird ein gleichmäßiger Kontakt zwischen Dielektrikum 4 und Polymer-Kunststoff 6 gewährleistet. Im nächsten Arbeitsschritt wird der Polymer-Kunststoff 6 verfestigt. Danach kann dieser einen gleichmäßigen Kontakt zur zweiten Elektrode 8 bilden. Durch die planare Ausführung können solche Bauelemente auch in integrierten Schaltungen, wie sie in Figur 2 dargestellt sind, eingesetzt werden. Sie lassen sich ferner im Inneren einer Leiterplatte anordnen.

In der Figur 2 ist ein Querschnitt einer erfindungsgemäßen Schaltung dargestellt. Die hier dargestellte Schaltung kann beispielsweise als Leistungskonverter eingesetzt werden. Dargestellt ist ein Schaltungsträger 9. Wie dargestellt, ist der Schaltungsträger 9 in mehrere Schichten aufgeteilt. So befinden sich kapazitive Schichten 10, die aus erster Elektrode 2, dielektrischer Schicht 4, Polymer-Kunststoff 6 und zweiter Elektrode 8 gebildet sind, in dem Schaltungsträger. Ferner befinden sich Widerstände 12, Dioden 14, Transistoren 18 und ein Steuer-IC 24 auf dem Schaltungsträger 9. Die einzelnen Elemente sind über Leitungen 26 sowohl horizontal, als auch vertikal miteinander verbunden. Jede einzelne Schicht kann strukturiert sein und so unterschiedliche Bauelemente nachbilden. Durch die Integration verschiedenster Bauelemente auf und in dem einen Schaltungsträger 9 ergibt sich eine hohe Integrationsdichte.

Die planare Ausführung der Elektrolyt-Kondensatoren erlaubt erstmalig, hochintegrierte Schaltungen auch mit hohen kapazitiven Eigenschaften zur Verfügung zu stellen. Integrierte Schaltkreise, die neben einer hohen Kapazität auch noch eine geringe Bauhöhe aufweisen, lassen sich erstmalig realisieren.

### BEZUGSZEICHENLISTE

- 2: erste Elektrode
- 4: dielektrische Schicht
- 6: Polymer-Kunststoff
- 8: zweite Elektrode
- 9: Schaltungsträger
- 10: kapazitive Schicht
- 12: Widerstände
- 14: Dioden
- 18: Transistoren
- 24: Steuer-IC
- 26: Leitungen

## Patentansprüche

1. Elektronisches Bauelement mit kapazitiven Eigenschaften, insbesondere Kondensatoren, mitzumindest einer ersten, eine leitfähige Schicht aufweisenden Elektrode (2), mit zumindest einer zweiten, eine leitfähige Schicht aufweisenden Elektrode (8),
mit zumindest einer zwischen der ersten und der zweiten Elektrode (2, 8) angeordneten leitfähigen Polymerschicht (6),
**dadurch gekennzeichnet,**
**dass** die Elektroden und die Polymerschicht zumindest einfach planar geschichtet sind und dass zumindest eine leitfähige Schicht zumindest eine dielektrische Schicht (4) aufweist.

2. Elektronische Bauelement nach Anspruch 1,
**dadurch gekennzeichnet,**
**dass** es auf oder in einem Schaltungsträger (9) angeordnet ist.

3. Elektronisches Bauelement nach Anspruch 2,
**dadurch gekennzeichnet,**
**dass** der Schaltungsträger (9) zusätzliche passive (10-22) und/oder aktive (24) elektronische Bauelemente aufweist.

4. Elektronisches Bauelement nach Anspruch 2,
**dadurch gekennzeichnet,**
**dass** der Schaltungsträger (9) mehrfach geschichtet ist.

5. Elektronisches Bauelement nach Anspruch 2,
**dadurch gekennzeichnet,**
**dass** der Schaltungsträger eine Halbleiterschicht, weichmagnetische Schicht, dielektrische Schicht und/oder Widerstandsschicht aufweist.

6. Elektronisches Bauelement nach Anspruch 2,
**dadurch gekennzeichnet,**
**dass** die Elektroden (2, 8) und/oder die Polymerschicht (6) strukturiert auf den oder in den Schaltungsträger (9) aufgebracht sind.

7. Elektronisches Bauelement nach Anspruch 2,
**dadurch gekennzeichnet,**
**dass** der Schaltungsträger (9) eine gedruckte Leiterplatte ist.

8. Verfahren zur Herstellung eines Bauelementes nach einem der Ansprüche 1 bis 7, bei dem auf einen Schaltungsträger zumindest eine erste leitfähige Schicht aufgebracht wird, bei dem auf die erste Schicht zumindest ein Dielektrikum aufgebracht wird, bei dem auf das Dielektrikum zumindest eine leitfähige Polymerschicht aufgebracht wird und bei dem auf die Polymerschicht zumindest eine zweite leitfähige Schicht aufgebracht wird.

9. Verwendung eines elektronischen Bauelementes nach einem der Ansprüche 1 bis 7 in Flachbildschirmen.

10. Verwendung eines elektronischen Bauelementes nach einem der Ansprüche 1 bis 7 in Leistungskonvertern, insbesondere Schaltnetzteilen.

11. Verwendung eines elektronischen Bauelementes nach Anspruch 10 als Filterkondensator.

12. Verwendung eines elektronischen Bauelementes nach Anspruch 10 als Energiespeicher , insbesondere Zwischenspeicher , zum Überbrücken von Netzausfällen, insbesondere mit der Länge von einer oder mehreren Netz-Halbwellen im ms-Bereich.

13. Verwendung eines elektronischen Bauelementes nach Anspruch 10 als funktionale Kondensatoren in Timing- oder Regelungsschaltkreisen.

14. Verwendung eines elektronischen Bauelementes nach einer der Ansprüche 1 bis 7,
**dadurch gekennzeichnet,**
**dass** es als Entkoppelung von HF-Signalen in DC-Bias- (Gleichstrom-Vorgangs-) Leitern dient.

15. Verwendung eines elektronischen Bauelementes nach einer der Ansprüche 1 bis 7,
**dadurch gekennzeichnet,**
**dass** es als Entkopplungskondensator zur Entkoppelung der Versorgungsspannung von Schaltungsteilen oder ICs voneinander dient.
